(19) Europäisches Patentamt
European Patent Office
Office européen des brevets

(11) **EP 3 095 890 B1**

(12) **EUROPÄISCHE PATENTSCHRIFT**

(45) Veröffentlichungstag und Bekanntmachung des Hinweises auf die Patenterteilung:
**29.08.2018 Patentblatt 2018/35**

(21) Anmeldenummer: **14878801.1**

(22) Anmeldetag: **14.01.2014**

(51) Int Cl.:
*C23C 4/00* (2016.01)    *C23C 14/24* (2006.01)
*C23C 14/56* (2006.01)    *C23C 14/50* (2006.01)

(86) Internationale Anmeldenummer:
**PCT/RU2014/000010**

(87) Internationale Veröffentlichungsnummer:
**WO 2015/108432 (23.07.2015 Gazette 2015/29)**

(54) **VERFAHREN ZUM AUFBRINGEN VON DÜNNFILMBESCHICHTUNGEN UND PRODUKTIONSLINIE ZUR DURCHFÜHRUNG DES VERFAHRENS**

METHOD FOR APPLYING THIN-FILM COATINGS AND MANUFACTURING LINE FOR IMPLEMENTING SAME

PROCÉDÉ D'APPLICATION DE REVÊTEMENT EN FILM FIN ET CHAÎNE INDUSTRIELLE POUR SA MISE EN OEUVRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**23.11.2016 Patentblatt 2016/47**

(73) Patentinhaber: **The Batteries spólka z ograniczona odpowiedzialnoscia**
**35-005 Rzeszów (PL)**

(72) Erfinder: **Khisamov, Ayrat Khamitovich**
**Ufa, 450097 (RU)**

(74) Vertreter: **Jeck, Anton**
**Jeck & Fleck**
**Patentanwälte**
**Klingengasse 2**
**71665 Vaihingen/Enz (DE)**

(56) Entgegenhaltungen:
**JP-A- 2007 077 478     US-A- 4 851 095**
**US-A1- 2003 003 767    US-A1- 2003 033 983**
**US-A1- 2005 186 346    US-A1- 2009 081 885**

**Beschreibung**

Die Gruppe von Erfindungen bezieht sich auf die Maschinentechnik zur Oberflächenbehandlung in der Massenfertigung und insbesondere auf Vakuummaschinentechnik, die für die Aufbringung von Dünnschichten mit vorgegebenen optischen, elektrischen und anderen Eigenschaften vorgesehen ist.

Aus dem Stand der Technik sind verschiedene Verfahren zur Auftragung von Dünnschichten auf Werkstücke (Träger) bekannt.

Das Patent US 4,851,095, veröffentlicht am 25.07.1989, beschreibt ein Verfahren zum Magnetronsputtern von Dünnschichten auf Substrate, die auf einer Drehtrommel angeordnet sind. Die Beschichtungen werden auf die Substrate mit Hilfe von Arbeitsorganen gespritzt, die in einem Vakuumraum rings um die Trommel angeordnet sind.

Die JP 2007 077478A offenbart ein Beschichtungssystem, welches mit drehbaren Trommeln ausgebildet ist, welche oberhalb eines Schmelztiegels verfahren werden und über diesen rotieren. Mittels von Trägereinrichtungen können die Trommeln in einer vorgegebenen Richtung bewegt werden.

Die Vorrichtung weist einen Vorbereitungsraum, einen filmbildenden Raum sowie ein Austrittsraum auf.

Die US 2005/0186346 A1 eine Beschichtungsvorrichtung, in welcher zu beschichtende Gegenstände über eine Rollenanordnung durch verschiedene Kammern geschleust werden.

Aus der US 2003/0003767 A1 geht eine Beschichtungsvorrichtung hervor, welche ausgebildet ist ein Substrat aufzunehmen und zu halten. Hierbei wird das zu beschließende Substrat in Rotation versetzt, während die Beschichtung aufgenommen wird.

Die Mängel dieser technischen Lösung sind niedrige Leistung und beachtliche Erzeugnisselbstkosten, die dadurch bedingt sind, dass die jeweiligen Prozessschritte wiederholt werden müssen, um die gewünschte Anzahl der Schichten in einer Struktur zu erreichen.

Der nächste Stand der Technik gegenüber dem beanspruchten Verfahren der Gesamtheit seiner wesentlichen Merkmale nach ist das im Patent US 6,893,544, (veröffentlicht 17.05.2005) offenbarte Verfahren zum Aufbringen von Dünnschichten, wonach die Substrate auf einem senkrechten flachen Förderwagen befestigt werden, der in einer Linien- Prozesseinrichtung bewegt wird (Magnetronsputtern-Katoden, lineare Plasmaquellen usw.).

Die Mängel dieses Verfahrens sind hohe Selbstkosten und geringe Leistungsfähigkeit, besonders bei der Herstellung von komplexen und Präzisions-Beschichtungen, weil dabei raffinierte Steuersysteme und Einstellungen angewendet werden müssen (also es geht um die unproduktive Zeit- und Materialverluste). Ein weiterer Mangel ist hoher Materialverbrauch. Er ist dadurch bedingt, dass das Behandlungsfeld der Prozesseinrichtung größer als der Gleichmäßigkeitsbereich ist. Somit trifft 30 bis 50 % des Targetmaterials zum Beispiel beim Magnetronsputtern nicht das Substrat und geht fehl. Darüber hinaus ist die Auswahl an anwendbaren Technologien und Prozesseinrichtungen begrenzt, denn es können nur solche Einrichtungen eingesetzt werden, die eine akzeptable Gleichmäßigkeit sicherstellen. Dadurch werden viele aussichtsreiche Technologien nicht anwendbar.

Aus dem Stand der Technik sind auch verschiedene Anlagen zum Aufbringen von Dünnschichten auf Werkstücke (Substrate) bekannt.

Insbesondere werden nichtkontinuierliche Trommelanlagen zur Behandlung von Kleinsubstraten bei der Massenfertigung angewendet. Dazu zählt zum Beispiel die durch das Patent US 4,851,095 (veröffentlicht am 25.07.1989) bekannte Anlage, die einen Substrathalter enthält. Beim Substrathalter handelt es sich um einen Zylinder, über dessen Zylindermantellinie Substrate verteilt sind. Die gleichmäßige Beschichtung in einer Richtung wird durch die drehende Trommel und in der anderen Richtung durch die linearen Prozesseinrichtungen sichergestellt.

Bei der Bildschirmfertigung, wo Flachsubstrate behandelt werden, werden Inline-Anlagen angewendet. Hier werden Substrate an Trägerwagen befestigt, die über alle nacheinander angeordneten Prozessstationen fahren. Als ein Beispiel für solche Anlagen gilt die automatisierte Anlage zur Herstellung von Dünnschichten nach dem Gebrauchsmuster RU 78785 (veröffentlicht am 10.12.2008). Jedoch ist diese Anlage, wie auch andere zur Zeit bekannten Inline-Anlagen, durch geringe Funktionssicherheit und hohe Selbstkosten bemängelt. Die mangelnde Funktionssicherheit ist darauf zurückzuführen, dass die zuverlässige Substratbefestigung von der Laufruhe des Transportsystems abhängig ist. Die hohen Selbstkosten sind durch die Anwendung von komplizierten Steuer- und Einstellsystemen bedingt, um die benötigte Gleichmäßigkeit bei der Beschichtung zu erreichen.

Der nächste Stand der Technik gegenüber der beanspruchten Erfindung der Gesamtheit ihrer wesentlichen Merkmale nach ist die Herstellungslinie zum Aufbringen von Dünnschichten gemäß dem Patent US 6,893,544 (veröffentlicht am 17.05.2005). Diese Herstellungslinie umfasst folgende Einrichtungen, die nacheinander angeordnet sind: Eine Schleusenkammer, eine Prozesskammer mit einer darin eingebauten Prozesseinrichtung, eine Austrittspufferkammer und ein flacher Substrathalter, der die Kammern entlang verfahrbar ist.

Diesem Stand der Technik sind folgende Mängel eigen:

-   begrenzte Auswahl an Baugrößen der zu bearbeiteten Substrate. Es ist insbesondere nicht möglich, flexible Substrate, zum Beispiel Dünnglas zu behalten, weil die zuverlässige Befestigung und Intaktheit solches Dünnglases während der Bewegung innerhalb der Herstellungslinie nicht sichergestellt werden kann;

- hohe Selbstkosten aufgrund der angewendeten komplizierten Steuer- und Einstellsystemen, besonders bei zusammengesetzten und Präzisionsbeschichtungen, sowie aufgrund des beachtlichen Materialverbrauchs, denn 30 bis 50 % des gesputterten Materials das Substrat verfehlt. Das ist dadurch bedingt, dass das Behandlungsfeld der Prozesseinrichtung größer als das Gleichmäßigkeitsfeld ausgebildet ist, um die Gleichmäßigkeit beim Sputtern sicherzustellen;

- begrenzte Auswahl an anwendbaren Technologien und Prozesseinrichtungen, weil die eventuelle Anwendung durch die Anforderungen an die akzeptable Gleichmäßigkeit der Auftragsschicht eingeschränkt wird.

Offenbarung der Gruppe von Erfindungen

Die vorliegende Gruppe von Erfindungen ist in Ansprüchen 1 und 2 angegeben. Die durch die vorliegende Gruppe von Erfindungen zu lösende Aufgabe ist die Entwicklung von einer hochleistungsfähigen genormten Anlagentechnik zur Behandlung von Substraten innerhalb eines breiten Baugrößenbereiches.

Der technische Effekt ist die Möglichkeit, sowohl große und flexible als auch Kleinsubstrate mit einem großen Gleichmäßigkeitsgrad der Beschichtung zu bearbeiten. Dabei soll eine größere Anzahl an vorhandenen Technologien und Prozesseinrichtungen anwendbar sein und ein hoher Nutzeffekt der verwendeten Auftragsmaterialien erreicht werden.

Der genannte technische Effekt wird wie folgt erreicht.

Das Verfahren zum Aufbringen von Dünnschichten auf ein Substrat umfasst folgende Schritte: Das Substrat wird auf einem Substrathalter angeordnet. Die Substrathalter mit den Substraten werden über Prozesskammern in einer bestimmten Reihenfolge gefahren. Die Beschichtung wird in den Prozesskammern mit Hilfe von Prozesseinrichtungen durchgeführt, welche in Prozesskammern eingebaut sind. Dabei sind die Substrathalter in Form von Drehtrommeln ausgebildet. Die Drehtrommeln werden über die Behandlungsfelder der Prozesseinrichtungen parallel zur Drehachse der Drehtrommeln bewegt und mit konstanten Linear- und Winkelgeschwindigkeiten gedreht. Dabei wird das Linear- und Winkelgeschwindigkeitsverhältnis aufgrund der Bedingung gewählt, dass jeder Punkt der Drehtrommeloberfläche wenigstens zwei Vollumdrehungen beim Durchgang durch die Behandlungsfelder der Prozesseinrichtung ausführt.

Der genannte technische Effekt wird auch dadurch erreicht, dass die Herstellungslinie zum Aufbringen von Dünnschichten Schleusenkammern, Pufferkammern und wenigstens eine Prozesskammer mit einer Prozesseinrichtung, Substrathalter und ein Transportsystem enthält. Die Substrathalter sind dabei an Wagen angebaut, welche so montiert sind, dass sie durch die Kammern in einer bestimmten Reihenfolge fahren können. Dabei ist jeder Substrathalter in Form von einer Drehtrommel ausgebildet, die auf dem jeweiligen Wagen koaxial mit seiner Bewegungsrichtung angebaut ist. Die Drehtrommeln sind mit einer konstanten Winkelgeschwindigkeit drehbar ausgebildet. Die Wagen sind mit einer konstanten Lineargeschwindigkeit verfahrbar ausgebildet, wobei wenigstens zwei Vollumdrehungen jedes Punktes der Drehtrommeloberfläche beim Durchgang durch die Behandlungsfelder der Prozesseinrichtung ausgeführt werden.

Um den genannten technischen Effekt zu erreichen, kann die Herstellungslinie je eine Eintritts-Schleusenkammer und -Pufferkammer sowie je eine Austritts-Pufferkammer und -Schleusenkammer enthalten. Darüber hinaus kann der Wagen des Substrathalters in Form von einer Aufhängung oberhalb des Substrathalters oder in Form von einem Rahmen, oder in Form von einem Transportwagen mit Linearführungen ausgebildet werden, wobei die Linearführungen unterhalb des Substrathalters liegen.

Die Herstellungslinie kann erfindungsgemäß auch wenigstens mit einem Drehantrieb für die Substrathalter ausgerüstet werden. Die Substrathalter können mit lösbaren Reibungs- und/oder magnetischen Kupplungen und/oder mit einem Niederspannungsmotor ausgestattet werden. Dabei kann jeder Substrathalter mit einem Motor versehen werden. Das Transportsystem kann mit Rollen und der Wagen mit Führungen versehen werden, die mit den Rollen zusammenwirken.

Dabei wird erfindungsgemäß die erforderliche Beschichtungsgleichmäßigkeit erreicht. Das realisierbare zugrunde liegende Prinzip wird dabei am Beschreibungsbeispiel der Bewegung des zylinderförmigen Substrathalters erklärt, welcher gleichmäßige Schwinghubbewegung durch das Behandlungsfeld einer Prozesseinrichtung ausführt. Bei der Bewegung des Zylinders wird in jedem der Punkte auf der Zylinderoberfläche, die die Zylindermantellinie ausbilden, eine gewisse Schichtdicke $f(x)$ pro jede Umdrehung aufgetragen. Dabei wird jeder betrachtete Punkt A bei jeder Umdrehung um einen Zylinderverschiebungsschritt d in den Punkt A' verschoben, und bei der nächsten Umdrehung wird darin eine Schichtdicke aufgetragen, die dem Punkt A' entspricht. Die im Punkt A beim Durchgang durch den gesamten Prozessbereich aufgebrachte Gesamtdicke T wird dadurch erreicht, dass die Werte einer durch die Punkte mit Schritt d erstellten Kurve summiert werden. Diese Summierung ist der Kurvenintegration nach der Midpoint Quadrature Methode mit dem Schritt d äquivalent. Für einen anderen Punkt B wird die gleiche Summierung erreicht, allerdings mit einem anderen Satz der Punkte. Das heißt: Für einen beliebigen Punkt wird eine geschätzte aufgebrachte Volldicke durch die Gleichung $T_0 = S/d$ festgelegt, wobei S die Fläche unter der Kurve ist. Die Genauigkeit dieser Schätzung nimmt mit der Schrittverringerung vom Schritt quadratisch abhängig zu. Die Schätzung des relativen Fehlers wird durch die den Ausdruck $R \leq \frac{M_2}{24 f_{av}} d^2$ beschrieben, wobei $f_{av}$ das Mittelwert von $f(x)$, $M_2$ der Maximalwert von $f''(x)$ ist. Bei dieser Schätzung handelt es sich um die Schätzung der Ungleichmäßigkeit der Beschichtungsdicke bei stabiler Funktion der Prozesseinrichtung.

Werden N identische gleichmäßig um einen Substrathalter verteilte Prozesseinrichtungen eingesetzt, so ist die vorangehende für eine einzelne Prozesseinrichtung angeführte Berechnung zutreffend, die man wiederholen kann, indem die Prozesseinrichtungen von 1 bis N durchgehend nummeriert werden. Dabei wird der jeweilige Beitrag der $k$-ten Prozesseinrichtung für jeden jeweiligen Punkt durch die Summe der Werte in den zur ersten Prozesseinrichtung um $d \times \frac{k-1}{N}$ verschobenen Punkten ermittelt sein. Werden nun alle Summierungspunkte in Deckung gebracht, so ergibt sich, dass alle Werte in Punkten mit dem $d/N$-Schritt summiert werden. Das heißt, die Anwendung solcher Konfiguration der Einrichtungen ist der $N$-fachen Verminderung des Integrationsschrittes und dementsprechend der $N^2$-fachen Verbesserung der Gleichmäßigkeit äquivalent.

Die erforderliche Gleichmäßigkeit kann durch folgende Maßnahmen erreicht werden:

- Einige identische Prozesseinrichtungen können rings um Substrathalter symmetrisch verteilt werden;
- Einige identische Einrichtungen können an der Substrathalterstrecke entlang mit einem Intervall $S = \left(m + \frac{1}{n}\right) * d$ angeordnet werden, wobei $m$ eine Ganzzahl, $n$ die Anzahl der Einrichtungen und d Linearverschiebung des Substrathalters innerhalb einer Umdrehung sind;
- Ein Teil des Sputternbereichs kann durch eine von außen gesteuerte Klappe verdeckt werden.

Hinsichtlich des Gleichmäßigkeitsprinzips soll auch betont werden, dass die Substrathalter ggfs. mit unterschiedlicher Geschwindigkeit durch die Prozesskammern gefahren werden können und nur im Behandlungsfeld sich mit einer konstanten Geschwindigkeit bewegen. Die Bewegungsmöglichkeit der Substrathalter innerhalb einer Prozesskammer mit unterschiedlicher Geschwindigkeit und zwar - gleichmäßige und konstante Geschwindigkeit im Behandlungsfeld und eine andere Geschwindigkeit außerhalb des Behandlungsfeldes aber innerhalb dieser Prozesskammer - ermöglicht es, die prinzipielle Bauweise (Zusammenstellung) der Herstellungslinie insgesamt zu optimieren. Das wird dadurch erreicht, dass die jeweils für das realisierbare Verfahren benötigten Prozesskammern eingesetzt werden können.

Diese technische Lösung erhöht ihrerseits die Produktionsleistung der Herstellungslinie.

Kurze Beschreibung der Zeichnungen

Die Gruppe von Erfindungen wird anhand der Zeichnungen veranschaulicht. Es zeigen:

Fig. 1 - Verteilungskurve einer pro Umdrehung auftragbaren Dicke für eine Prozesseinrichtung (die Werte auf X Achse sind dabei in mm zum Mittelpunkt der Einrichtung angegeben);
Fig. 2 - perspektivische Ansicht des Substrathalters;
Fig. 3 - Vorderansicht des Substrathalters;

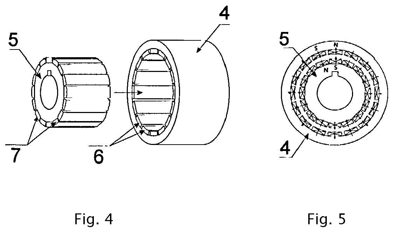

Fig. 4 - perspektivische Ansicht der Elemente der magnetischen Kupplung;
Fig. 5 - Vorderansicht der magnetischen Kupplung;

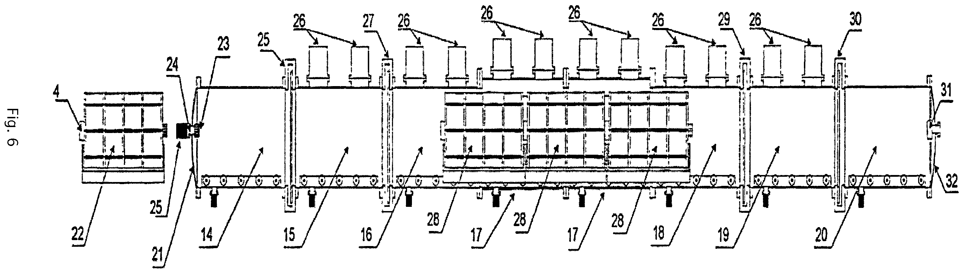

Fig. 6 - Übersichtsschema der Herstellungslinie.

Durchführung der Gruppe von Erfindungen

Das beanspruchte Verfahren zum Aufbringen von Dünnschichten auf ein Substrat kann an einem Beispiel des Arrangements der Prozesseinrichtungen in einer Anlage zum Aufbringen vom Vierschicht- Antireflexbelag aufs Glas veranschaulicht werden. Die Anforderungen an die Gleichmäßigkeit der Schichten sind $\pm 1\%$ für die erste und die zweite Schicht und $\pm 3\%$ für die dritte und die vierte Schicht.

Der Substrathalter ist 100 cm lang. Die Bewegungsgeschwindigkeit der Substrathalter innerhalb des Prozessbereichs wird durch den Arbeitstakt der Anlage festgelegt und beträgt 1 m/Min.

Für den Beschichtungsvorgang sind insgesamt vier Prozessbereiche je ein Prozessbereich pro Schicht vorgesehen. Als Prozesseinrichtungen werden Mittelfrequenz-Magnetrone mit einem 800 mm langen Target eingesetzt. Die Anzahl der Prozesseinrichtungen wird durch die Anforderungen an die Leistung und die Schichtdicken festgelegt. Um die erste Schicht (Siliziumoxid) aufzubringen, wird eine Prozesseinrichtung 01 verwendet. Für die zweite Schicht (Titanoxid) werden zwei Prozesseinrichtungen 02, für die dritte Schicht (Siliziumoxid) und die vierte Schicht (Titanoxid) jeweils je vier Prozesseinrichtungen 03 und 04 verwendet.

Da für die ersten zwei Schichten strengere Anforderungen hinsichtlich der Gleichmäßigkeit gelten, und für die erste Schicht am wenigsten Prozesseinrichtungen benutzt werden, wird die für die Gleichmäßigkeit benötigte Drehgeschwindigkeit von der ersten Schicht abhängig sein sein.

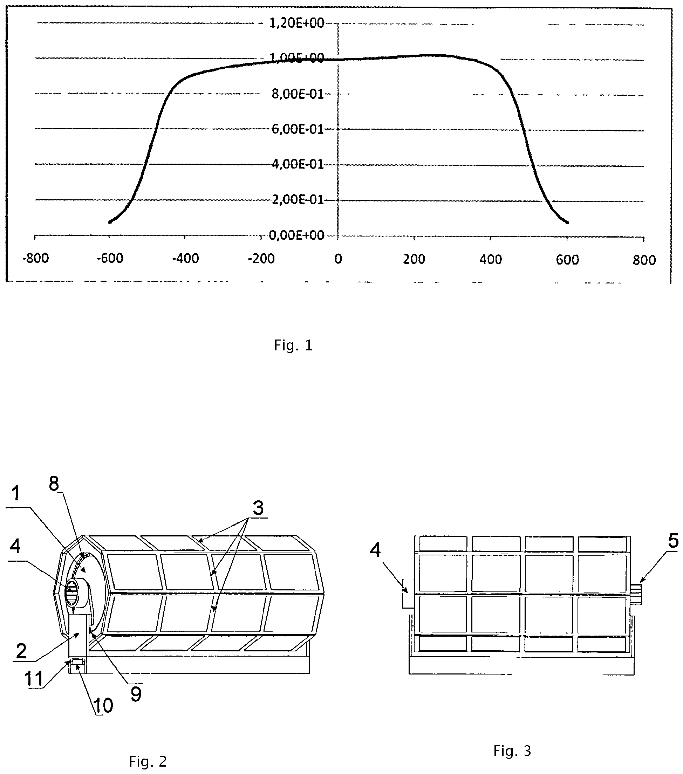

Das Verteilungsbeispiel einer pro Umdrehung durch eine Prozesseinrichtung erstellbaren Dicke ist als eine Kurve (Fig. 1) dargestellt, wobei die Werte auf X Achse in mm zum Mittelpunkt der Einrichtung angegeben sind.

Gemäß dem angeführten Kurvenbild beträgt die Längenausdehnung des Behandlungsfeldes 120 cm.

Die Länge der Randbereiche, wo die Dicke bis aufs Null vermindert wird, beträgt dabei ca. 10 cm.

Bei zwei Umdrehungen des Substrathalters wird die Ungleichmäßigkeit während des Durchgangs des Behandlungsfeldes ca. ±35% betragen: Die Mindestdicke wird in einem Punkt vorliegen, der auf die Ränder und auf den Mittelpunkt des Behandlungsfeldes fällt. Die Maximaldicke wird in einem der Punkte beobachtet, der zweimal ins Behandlungsfeld fällt. Dieses Dickenverhältnis wird bei ca. 1:2 liegen. Das ergibt die Ungleichmäßigkeit von ±33%.

Um die erforderliche Gleichmäßigkeit zu erreichen, soll dieser Wert um das 35-fache vermindert werden. Das ergibt die schätzbare Anzahl der Umdrehungen

$$2 * \sqrt{35} \approx 12.$$

Eine genauere Schätzung anhand der Kurve zeigt, dass die Ungleichmäßigkeit bei solcher Umdrehungsanzahl ±0,8% beträgt.

Folglich soll die Drehgeschwindigkeit des Substrathalters so eingestellt werden, dass die lineare Verschiebung des Substrathalters pro Umdrehung max. 120/12 = 10 cm beträgt. Bei der fortschreitenden Bewegungsgeschwindigkeit von 1 m/Min. wird die Drehgeschwindigkeit von min. 10 U/Min. gewählt.

Für die übrigen Schichten wird eine bessere Gleichmäßigkeit erreicht sein, weil die Verwendung von zwei und mehr identischen Prozesseinrichtungen der proportionalen Steigerung der Drehgeschwindigkeit, d.h. der Verbesserung der Gleichmäßigkeit äquivalent ist.

Die Funktion der beanspruchten Herstellungslinie kann am Beispiel eines linearen Arrangements mit zweistufiger Schleusung betrachtet werden. Das Arrangement umfasst einen Substrathalter, einen Vakuumverschluß, eine Niedervakuum-Eintrittsschleusenkammer, eine Hochvakuum-Eintrittsschleusenkammer, eine Eintrittspufferkammer, eine Prozesskammer, eine Austrittspufferkammer, eine Hochvakuum-Austrittsschleusenkammer, eine Niedervakuum-Austrittsschleusenkammer, ein Transportsystem mit Antriebsrollen, Hochvakuumpumpen und Prozesseinrichtungen. Beim Substrathalter handelt es sich um eine Drehtrommel (1), die auf einem Wagen (2) gelagert ist. Die Substrate, zum Beispiel, Gläser werden an den Platten (3) nach einem beliebigen Verfahren befestigt, welches ihre zuverlässige Fixierung beim Drehen der Drehtrommel sicherstellt.

Der Wagen ist mit Führungen (10) versehen, die sich unterhalb der Drehtrommel befinden und auf Stützen (11) aus einem dielektrischen Stoff angebaut sind.

In manchen Fällen kann der Wagen (2) je nach dem anwendbaren Fertigungsprozess wie folgt ausgebildet werden:

- in Form von einem Wagen, wenn Linearführungen unterhalb der Drehtrommel liegen;
- in Form von einer Aufhängung, wenn Linearführungen sich oberhalb der Drehtrommel befinden;

- in Form von einem Rahmen, wenn Linearführungen an verschiedenen Seiten der Drehtrommel angeordnet sind.
- oder auf eine andere Weise, welche die Möglichkeit der linearen Bewegung des drehbaren Zylinders sicherstellt.

An den Wellenstümpfen der Drehtrommel sind Elemente (4) und (5) einer lösbaren magnetischen Kupplung angeordnet. Die Bauweise der Kupplung ist allgemein bekannt. Bei dem ersten Element (4) der lösbaren Kupplung handelt es sich um einen Hohlzylinder aus einem weichmagnetischen Stoff, an dessen Oberfläche Magneten (6) befestigt sind. Die Magneten sind mit alternierender Polarität angebaut, wobei Magnetisierungsrichtungen in der Zeichnung angegeben sind. Das Gegenstück (5) der magnetischen Kupplung ist ein Zylinder aus weichmagnetischem Stoff mit an seiner Oberfläche befestigten Magneten (7), deren Anzahl mit der Anzahl der Magneten des ersten Elements zusammenfällt. Die Magneten sind mit alternierender Polarität angebaut, deren Magnetisierungsrichtungen auf der Zeichnung angegeben sind. Zwischen den Magneten des ersten und des zweiten Elements gibt es einen Abstand von ca. 5 mm. Dadurch wird die Berührung beim Durchdrehen der Kupplung im Falle einer unpräzisen Zusammenfügung der Substrathalter vermieden.

Um die Drehung der Drehtrommel aufrechtzuerhalten, ist ein direkter elektrischer Antrieb angewendet. Der Läufer des elektrischen Antriebs (8) ist durch einen Ringkern mit daran angebauten Magneten gebildet. Der Ständer des elektrischen Antriebs (9) mit einer Steuereinheit ist auf einem Rahmen eines Wagens angebaut. Der elektrische Antrieb wird mit Gleichstrom über Linearführungen des Wagens (10) gespeist. Dafür sind die Linearführungen am Wagen auf isolierenden Stützen (11) befestigt. Die Linearführungen werden durch die Rollen des Transportsystems gespeist.

Die Herstellungslinie besteht aus einer Niedervakuum-Eintrittsschleusenkammer (14), einer Hochvakuum-Eintrittsschleusenkammer (15), einer Eintrittspufferkammer (16), Prozesskammern (17) mit darin eingebauten Prozesseinrichtungen, einer Austrittspufferkammer (18), einer Hochvakuum-Austrittsschleusenkammer (19) und einer Niedervakuum-Austrittsschleusenkammer (20).

Die Prozesseinrichtungen werden die Bewegungsstrecke der Substrathalter entlang angebaut. Das Behandlungsfeld wird als ein Gebiet die Bewegungsstrecke der Substrathalter entlang definiert. In diesem Gebiet befindet sich die Prozesseinrichtung. Innerhalb dieses Gebiets trifft der Hauptanteil (über 90%) des durch diese Prozesseinrichtung auftragbaren Stoffes den Substrathalter. Dabei werden einige Prozesseinrichtungen, die für das Aufbringen des gleichen Stoffes vorgesehen sind und sich völlig oder teilweise überlappende Behandlungsfelder bilden, als eine Prozesseinrichtung betrachtet. Unter Umständen können einige bei der Beschichtung benutzte Prozesseinrichtungen rings um die Substrathalter angeordnet werden.

Der Substrathalter (22) mit darauf befestigten Substraten kommt in die Eintritts-Schleusenkammer (14). Tür (21) der Schleusenkammer wird zugemacht. Danach fährt der Substrathalter zurück und seine lösbare Kupplung (4) greift in ein Gegenstück (23) der Kupplung ein, welches an einer Welle einer Vakuum-Drehdurchführung befestigt ist, die durch einen E-Motor (24) angetrieben wird, welcher an der Tür der Schleusenkammer (25) montiert ist.

Der E-Motor beschleunigt die Drehtrommel des Substrathalters auf die Soll-Drehgeschwindigkeit. Gleichzeitig erfolgt die Schleusenkammer-Evakuierung bis auf einen Druck zwischen 10 und 20 Pa.

Nach der Evakuierung und der Beschleunigung der Drehtrommel wird ein Transport-Vakuumverschluß (25) geöffnet. Ein Halter der Wagen fährt in die Hochvakuum-Eintrittsschleusenkammer (15). Der Vakuumverschluß (25) geht zu. Die Hochvakuum-Schleusenkammer ist mit Turbomolekularpumpen (26) versehen und sie wird bis zu einem Druck von <0,01 Pa evakuiert.

Nach der Evakuierung der Hochvakuum-Schleusenkammer wird ein Transport- Vakuumverschluß (27) aufgemacht. Der Substrathalter fährt in die Eintritts-Pufferkammer (16). Der Vakuumverschluß (27) schließt sich. Der Substrathalter wird in der Pufferkammer bis auf die Prozessgeschwindigkeit verzögert und mit dem Substrathalter zusammengefügt, welcher die Herstellungslinie im vorhergehenden Takt betreten hat. Die magnetischen Kupplungen der Substrathalter kommen in Eingriff, und die Drehung des eingetretenen Substrathalters wird mit der Drehung der Substrathalter (28) synchronisiert, die über die Prozesskammer gehen. In der Prozesskammer werden die Rollen des Transportsystems mit Strom gespeist, so dass die

Niederspannungsmotoren der Substrathalter die Drehung ihrer Drehtrommeln unterstützen.

Beim Durchgang durch Prozesskammern (17) wird das Substrat beschichtet. Während des Behandlungsvorganges des Substrats (beim Durchgang der Behandlungsfelder) dreht die Drehtrommel und fährt gleichmäßig ihre Achse entlang. Die Substrathalter bewegen sich durch die Behandlungsfelder mit einem minimalen Abstand zueinander.

Mit Rücksicht darauf, dass die Gleichmäßigkeit hauptsächlich durch einen Verschiebungsschritt pro Umdrehung festgelegt wird, wird das Verhältnis zwischen der linearen Verschiebungsgeschwindigkeit und der Drehgeschwindigkeit des Substrathalters so eingestellt, dass jeder Punkt auf der Oberfläche des Substrathalters beim Durchgang der Behandlungsfelder wenigstens zwei Vollumdrehungen ausführt. Somit ist der Zylinderverschiebungsschritt innerhalb einer Umdrehung klein genug und ermöglicht es, hohe Gleichmäßigkeit der aufgebrachten Beschichtungen unabhängig von den benutzten Bauarten der Prozesseinrichtungen einschließlich der linearen und Punkteinrichtungen sicherzustellen.

Die Aufgabe der Sicherstellung der erforderlichen Drehgeschwindigkeit des Substrathalters kann während der Behandlung bei gleichzeitiger linearer Bewegung mit Hilfe von einem der folgenden Verfahren realisiert werden:

1. Der Substrathalter wird durch einen externen Antrieb in einer der Eintrittskammern auf die erforderliche Geschwindigkeit beim unbeweglichen Wagen beschleunigt und dann setzt seine Drehung im Nachlauf fort.

2. Jeder Wagen wird mit einem Niederspannungsmotor ausgerüstet. Der Niederspannungsmotor wird über die Rollen des Transportsystems oder über einzelne Kontaktrollen und Linearführungen des Wagens gespeist, welche vom Gehäuse des Wagens isoliert sind.

3. Der Substrathalter wird auf die erforderliche Geschwindigkeit durch einen externen Antrieb in einer der Eintrittskammern beim unbeweglichen Wagen beschleunigt. Dabei wird der Wagen mit einem Niederspannungsmotor versehen, der nur dafür benutzt wird, um die Drehung fortzusetzen, und sehr kleine Leistung haben kann.

Um die gleiche Drehgeschwindigkeit aller Substrathalter im Behandlungsfeld sicherzustellen, können diese mit lösbaren Reibungs- oder magnetischen Kupplungen versehen werden. Sie sorgen für die Drehübertragung zwischen Nachbarsubstrathaltern bei ihrer Bewegung mit einem minimalen Abstand.

Um Metall-Isolator-Beschichtungen und Metall-Isolator-Verbundbeschichtungen aufzutragen, kann neben den traditionellen Verfahren für die Durchlaufanlagen eines der folgenden Verfahren eingesetzt werden und zwar: Mehrfache Dünnmetallschichtauftragung oder mehrfache unteroxidierte Dünnschichtauftragung mit nachfolgender Oxydation.

Unter Oxidation wird in diesem Fall eine beliebige Reaktion gemeint, die die Bildung einer chemischen Verbindung zum Beispiel mit Sauerstoff, Stickstoff, Selen usw. hervorruft.

Dafür wird ein spezieller Prozessbereich vorgesehen, worin Prozesseinrichtungen rings um den Substrathalter angeordnet werden, um ein oder mehrere Metalle aufzutragen, sowie eine Prozesseinrichtung zur Oxidation, bei der es sich um eine Quelle des aktivierten Reaktionsgases (zum Beispiel, eine Plasmaquelle) handelt.

In dem Prozessbereich werden die Mittel für Hochvakuum-Evakuierung eingebaut, die Gastrennung zwischen der Prozesseinrichtung für Oxidation und Prozesseinrichtungen für Metallspritzen sicherstellen. Dadurch wird stabile und leistungsstarke Funktion der Prozesseinrichtungen für Metallspritzen sichergestellt.

Beim Durchgang durch diesen Prozessbereich verläuft jeder Punkt der zu bearbeiteten Oberfläche mehrmals der Reihe nach an der Prozesseinrichtungen für Metallspritzen, wo eine superdünne Stoffschicht aufgebracht wird, und an der Prozesseinrichtung für Oxidation, wo diese Schicht vollständig oxidiert wird, vorbei. Nach dem Durchgang durch den Prozessbereich bekommt die zu bearbeitete Oberfläche eine gleichmäßige Metall-Isolator-Schicht oder Metall-Isolator-Verbundschicht mit einer vorgegebenen Zusammensetzung.

Die Prozesseinrichtungen können einen oder verschiedene Stoffe aufbringen. Im letzten Fall können unterschiedliche Beschichtungsgeschwindigkeiten je nach erforderlicher Zusammensetzung der Deckschicht eingestellt werden.

Nach dem Durchgang durch die Prozesskammern (17) kommt der Substrathalter in eine Austrittspufferkammer (18).

Ein Transport-Vakuumverschluß (29) öffnet sich. Der Substrathalter wird beschleunigt, indem er sich von dem nächsten Substrathalter trennt, und fährt in eine Hochvakuum-Austrittsschleusenkammer (19) weiter. Danach wird ein Vakuumverschluß (29) geschlossen. Ein Transport-Vakuumverschluß (30) öffnet sich und der Substrathalter fährt in eine Niedervakuum-Austrittsschleusenkammer (20), wo das vordere Element der magnetischen Kupplung des Substrathalters mit seinem Gegenstück (31) der magnetischen Kupplung zusammengefügt wird, das an der Tür montiert ist. Das Gegenstück (31) der magnetischen Kupplung ist an einer Welle befestigt, deren Drehung aufgrund der Reibung erschwert ist.

Der Vakuumverschluß (30) wird geschlossen. Die Kammer wird mit Trockenluft gefüllt. Der Druck steigt bis zum Normaldruck. Um diese Zeit stoppt die Drehtrommel des Substrathalters infolge der Bremsung der Kupplung (31).

Nach dem Druckausgleich in der Austritts-Schleusekammer (20) mit Normaldruck wird Tür (32) der Kammer aufgemacht, und der Substrathalter läuft aus der Herstellungslinie.

**Patentansprüche**

1. Verfahren zum Aufbringen von Dünnschichten auf Substrate, wonach

   - die Substrate auf Substrathaltern (22) angeordnet werden, welche jeweils an einen Wagen (2) angebaut sind und so montiert sind, dass sie durch die Prozesskammern (17) in einer bestimmten Reihenfolge fahren, und
   - die Substrathalter (22) durch die Prozesskammern (17) der Reihe nach gefahren werden, wobei die Beschichtung in den Prozesskammern (17) mit Hilfe von darin eingebauten Prozesseinrichtungen erfolgt, und

   - wobei die Substrathalter in Form von Drehtrommeln ausgebildet sind,
   - wobei die Drehtrommeln dabei durch Behandlungsfelder der Prozesseinrichtungen parallel zur Drehachse der Drehtrommeln gefahren und beim Durchgang durch die Prozesskammern (17) mit konstanten Linear- und Winkelgeschwindigkeiten gedreht werden, **dadurch gekennzeichnet,**
   - **dass** die Substrathalter (22) jeweils durch einen externen Antrieb (24) in zumindest einer Schleusenkammer (13, 14) auf die erforderliche Winkelgeschwindigkeit beim unbeweglichen Wagen (2) beschleunigt werden und ihre Drehung im Nachlauf fortsetzen,
   - **dass** jeder Wagen (2) mit einem Niederspannungsmotor zur Drehung des Substrathalters ausgerüstet ist, welcher über Rollen eines Transportsystems oder über einzelne Kontaktrollen und Linearführungen des Wagens (2) gespeist werden, welche von einem Gehäuse des Wagens isoliert sind, und
   - **dass** das Linear- und Winkelgeschwindigkeitsverhältnis aufgrund einer Bedingung gewählt wird, dass jeder Punkt der Drehtrommeloberfläche
   - wenigstens zwei Vollumdrehungen beim Durchgang durch die Behandlungsfelder der Prozesseinrichtung (17) ausführt.

2. Herstellungslinie zum Aufbringen von Dünnschichten mit

   - Schleusenkammern (13, 14),
   - Pufferkammern (16, 18) und
   - wenigstens einer Prozesskammer (17) einschließlich einer Prozesseinrichtung, Substrathalter (22), die an Wagen (2) angeordnet und so montiert sind, dass sie durch die Kammern (17) in einer bestimmten Reihenfolge fahren können,
   - sowie mit einem Transportsystem,
   - wobei jeder Substrathalter (22) in Form von einer Drehtrommel ausgebildet ist, die auf einem Wagen (2) koaxial mit seiner Bewegungsrichtung angebaut ist,
   - wobei die Wagen mit einer konstanten Lineargeschwindigkeit verfahrbar aus gebildet sind,
   - wobei die Drehtrommeln beim Durchgang durch die Prozesskammer (17) mit einer konstanten Winkelgeschwindigkeit drehbar ausgebildet sind,

   **dadurch gekennzeichnet,**

   - **dass** ein externer Antrieb (24) in zumindest einer Schleusenkammer (13, 14) vorgesehen ist, mittels welchem die Substrathalter (22) jeweils auf die erforderliche Winkelgeschwindigkeit bei unbeweglichen Wagen (2) beschleunigbar sind, wobei die Drehung der Substrathalter (22) im Nachlauf fortsetzbar ist,
- **dass** jeder Wagen (2) mit einem Niederspannungsmotor zur Drehung des Substrathalters ausgerüstet ist, welcher über Rollen eines Transportsystems oder über einzelne Kontaktrollen und Linearführungen des Wagens gespeist werden, welche von einem Gehäuse des Wagens (2) isoliert sind,
- **dass** beim Durchgang durch Behandlungsfelder der Prozesseinrichtung wenigstens zwei Vollumdrehungen jedes Punktes der Drehtrommeloberfläche ausgeführt werden.

3. Herstellungslinie nach Anspruch 2,
**dadurch gekennzeichnet,**
**dass** sie eine Eintritts-Schleusenkammer (14) und eine Eintritts-Pufferkammer (16) sowie eine Austritts-Austrittspufferkammer (18) und eine Austritts-Schleusenkammer (20) enthält.

4. Herstellungslinie nach Anspruch 2,
**dadurch gekennzeichnet,**
**dass** der Wagen (2) des Substrathalters (22) in Form von einer Aufhängung oberhalb des Substrathalters ausgebildet ist.

5. Herstellungslinie nach Anspruch 2,
**dadurch gekennzeichnet,**
**dass** der Wagen (2) des Substrathalters (22) in Form von einem Rahmen ausgebildet ist.

6. Herstellungslinie nach Anspruch 2,
**dadurch gekennzeichnet,**
**dass** der Wagen (2) des Substrathalters (22) in Form von einem Transportwagen mit Linearführungen ausgebildet sind, wobei die Linearführungen unterhalb des Substrathalters liegen.

7. Herstellungslinie nach Anspruch 2,
**dadurch gekennzeichnet,**
**dass** sie mit wenigstens einem Drehantrieb der Substrathalter (22) versehen ist.

8. Herstellungslinie nach Anspruch 7,
**dadurch gekennzeichnet,**
**dass** die Substrathalter (22) mit lösbaren Reibungs- und/oder magnetischen Kupplungen ausgerüstet sind.

9. Herstellungslinie nach Anspruch 2,
**dadurch gekennzeichnet,**
**dass** das Transportsystem mit Rollen und der Wagen mit Führungen versehen werden, die mit den Rollen zusammenwirken.

## Claims

1. A method for applying thin films to substrates, according to which

- substrates are located on substrate holders (22) which are each installed on a carriage (2) and mounted such that they move through the processing chambers (17) in a specified order, and
- the substrate holders (22) are moved through the processing chambers (17) in order, and the coating is done in the processing chambers (17), with the aid of processing devices built into them, and
- wherein the substrate holders are embodied in the form of rotary drums,
- and wherein the rotary drums are moved through treatment areas of the processing devices parallel to the axis of rotation of the rotary drums, and on passage through the processing chambers (17) they are rotated at constant linear and angular speeds, **characterized in that**
- the substrate holders (22) are each accelerated by an external drive (24) to the requisite angular speed in at least one sluice chamber (13, 14) while the carriage (2) is immovable, and continue their rotation thereafter;
- that each carriage (2) is equipped with a low-voltage motor for rotating the substrate holder, which motor is fed via rollers of a transportation system or via individual contact rollers and linear guides of the carriage (2), which are insulated from a housing of the carriage; and
- that the linear and angular speed ratio is selected on the basis of a condition that each point of the rotary drum surface
- executes at least two complete rotations upon passage through the treatment areas of the processing device (17).

2. A production line for applying thin films having

- sluice chambers (13, 14),
- buffer chambers (16, 18) and
- at least one processing chamber (17), including a processing device, substrate holders (22) that are located on the carriage (2) and mounted such that they can move through the chambers (17) in a specified order,
- and having a transportation system,
- wherein each substrate holder (22) is embodied in the form of a rotary drum, which is built onto a carriage (2) coaxially with the movement direction thereof,
- wherein the carriages are embodied as movable at a constant linear speed,

- wherein the rotary drums upon passage through the processing chamber (17) are embodied as rotatable at a constant angular speed, **characterized in that**

- an external drive (24) is provided in at least one sluice chamber (13, 14), by means of which drive the substrate holders (22) are each acceleratable to the requisite angular speed while the carriages (2) are immovable, and the rotation of the substrate holders (22) can be continued thereafter;

- that each carriage (2) is equipped with a low-voltage motor for rotating the substrate holder, which motor is fed via rollers of a transportation system or via individual contact rollers and linear guides of the carriage (2), which are insulated from a housing of the carriage;

- that upon passage through treatment areas of the processing device, at least two complete rotations of each point of the rotary drum surface are executed.

3. The production line of claim 2, **characterized in that**
it includes an inlet sluice chamber (14) and an inlet buffer chamber (16) as well as an outlet buffer chamber (18) and an outlet sluice chamber (20).

4. The production line of claim 2, **characterized in that**
the carriage (2) of the substrate holders (22) is embodied in the form of a hanger above the substrate holder.

5. The production line of claim 2, **characterized in that**
the carriage (2) of the substrate holders (22) is embodied in the form of a frame.

6. The production line of claim 2, **characterized in that**
the carriage (2) of the substrate holders (22) is in the form of a transport carriage with linear guides, and the linear guides are located below the substrate holder.

7. The production line of claim 2, **characterized in that**
it is provided with at least one rotary drive of the substrate holders (22).

8. The production line of claim 7, **characterized in that**
the substrate holders (22) are equipped with detachable friction couplings and/or magnetic couplings.

9. The production line of claim 2, **characterized in that**

the transportation system is provided with rollers and the carriage is provided with guides, which cooperate with the rollers.

**Revendications**

1. Dispositif d'application de couches minces sur des substrats disposés sur des supports de substrats (22) installés respectivement sur un véhicule (2) et montés d'une telle manière qu'ils passent par une chambre de traitement (17) dans un ordre bien déterminé et que les supports de substrats (22) traversent les chambres de traitement (17) dans l'ordre où le revêtement dans les chambres de traitement (17) se fait grâce à des moyens de traitement incorporés et où les supports de substrats sont formés sous forme de tambours rotatifs et où les tambours rotatifs passent par les champs de traitement des moyens de traitement parallèlement à l'axe de rotation des tambours rotatifs et qui tournent lors du passage des chambres de traitement (17) avec une vitesse linéaire et angulaire,
est caractérisé de sorte que
les supports de substrats (22) s'accélèrent respectivement par une commande externe (24) dans au minimum un compartiment d'évacuation (13,14) à la vitesse angulaire requise en véhicule immobile (2) et continuent leur rotation en fonctionnement retardé,
chaque véhicule (2) est équipé d'un moteur de basse tension en vue de la rotation du support du substrat alimenté via les rouleaux d'un système de transport ou via des rouleaux de contact et des guidages linéaires du véhicule (2) isolés du boîtier du véhicule et que le rapport de vitesse linéaire et angulaire est choisi suite à la condition que chaque point de la superficie du tambour rotatif exécute au minimum deux rotations complètes lors du passage par les champs de traitement du moyen de traitement (17).

2. Ligne de production pour l'application de couches minces avec

- Compartiments d'évacuation (13,14),
- Champs de tampon (16,18) et
- au minimum un champ de traitement (17) y compris un moyen de traitement, des supports de substrats (22) disposés sur le véhicule (2) et montés de telle manière qu'ils traversent les chambres (17) dans un ordre bien déterminé,
- ainsi qu'avec un système de transport

Où chaque support de substrats (22) est formé sous forme de tambour rotatif monté sur un véhicule (2) coaxialement avec sa direction de mouvement,
Où les tambours rotatifs sont formés rotativement lors du passage par la chambre de traitement (17) avec une vitesse angulaire constante.

Est caractérisé de sorte qu'

Une commande externe (24) est prévue dans au minimum un compartiment d'évacuation (13,14) grâce auquel les supports de substrats (22) sont accélérables respectivement sur la vitesse angulaire requise en véhicule immobile (2) où la rotation des supports de substrats (22) continue en fonctionnement retardé,

Que chaque véhicule (2) est équipé d'un moteur de basse tension en vue de la rotation du support des substrats qui sont alimentés via les rouleaux d'un système de transport et de rouleaux de contact différents ainsi que par des guidages linéaires du véhicule isolés d'un boîtier du véhicule (2),

Que lors du passage dans les champs de traitement des moyens de traitement au minimum deux rotations complètes de chaque point de la superficie du tambour rotatif sont exécutées,

3. Ligne de production selon la revendication 2 est **caractérisée** de sorte qu' Elle contient un compartiment d'évacuation d'entrée (14) et une chambre tampon d'entrée (16) ainsi qu'une chambre tampon de sortie (18) et un compartiment d'évacuation de sortie.

4. Ligne de production selon la revendication 2 est **caractérisée** de sorte que Le véhicule (2) du support des substrats (22) est formé sous forme de suspension au-dessus du support des substrats.

5. Ligne de production selon la revendication 2 est **caractérisée** de sorte que Le véhicule (2) du support des substrats (22) est formé sous forme de cadre.

6. Ligne de production selon la revendication 2 est **caractérisée** de sorte que Le véhicule (2) du support des substrats (22) est formé sous forme d'un véhicule de transport avec guidages linéaires où les guidages linéaires se situent au-dessous du support des substrats.

7. Ligne de production selon la revendication 2 est **caractérisée** de sorte qu' Elle équipée au minimum d'un vérin rotatif des supports de substrats (22).

8. Ligne de production selon la revendication 7 est **caractérisée** de sorte que Les supports de substrats (22) sont pourvus d'embrayages amovibles de friction et/ou d'embrayages amovibles magnétiques.

9. Ligne de production selon la revendication 2 est **caractérisée** de sorte que Le système de transport est muni de rouleaux, tandis que le véhicule est équipé de guidages interagissant avec les rouleaux.

Fig. 1

Fig. 2

Fig. 3

Fig. 4                    Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4851095 A
- JP 2007077478 A
- US 20050186346 A1
- US 20030003767 A1
- US 6893544 B
- RU 78785